# EUROPÄISCHE PATENTSCHRIFT

(11) **EP 0 651 912 B1**
(45) Veröffentlichungstag und Bekanntmachung des Hinweises auf die Patenterteilung: **20.01.1999**
(21) Anmeldenummer: 93915660.0
(22) Anmeldetag: 21.07.1993
(51) Int. Cl.: H01L 23/057, H01L 23/04, H01L 23/00, H01L 23/498

(54) **LEITERKARTE MIT MINIATURGEHÄUSE FÜR ELEKTRONISCHE KOMPONENTEN**
WIRING BOARD WITH MINIATURE HOUSING FOR ELECTRONIC COMPONENTS
PLAQUETTE DE CIRCUIT AVEC BOITIER MINIATURISE POUR COMPOSANTS ELECTRONIQUES

(30) Priorität: 22.07.1992 DE 4224103
(43) Veröffentlichungstag der Anmeldung: 10.05.1995
(73) Patentinhaber: MICHALK, Manfred, D-99096 Erfurt (DE)
(72) Erfinder: MICHALK, Manfred, D-99096 Erfurt (DE)
(74) Vertreter: Liedtke, Klaus, Dr.
(86) Internationale Anmeldenummer: DE9300654
(87) Internationale Veröffentlichungsnummer: WO9402960

(56) Entgegenhaltungen:
- EP-A- 36 671
- EP-A- 163 082
- EP-A- 359 328
- EP-A- 391 790
- FR-A- 2 192 375
- FR-A- 2 205 745
- FR-A- 2 283 551
- US-A- 4 831 495

## Beschreibung

Die Erfindung betrifft eine Leiterkarte mit Miniaturgehäuse für elektronische Komponenten, vorzugsweise für die geschützte Anordnung von elektronischen Komponenten wie Halbleiterchips und dergleichen.

Mit Kontakten versehene sowie kontakt lose Chipkarten, Identifikationsmodule und sehr flache, flexible Leiterkarten werden in verstärkten Maße als Informationsträger verwendet.

Um die bestehenden Abmessungsnormen und die Anforderungen an die mechanische Belastbarkeit von Plastikkarten zu erfüllen (z.B. ISO 7816), ist es erforderlich, sehr flache elektronische Bauelemente in die Leiterkarten, Trägerplatinen oder Module einzusetzen und Bauelemente und Verbindungstechniken so zu gestalten, daß die beispielsweise beim Gebrauch von Chipkarten auftretenden Biegekräfte keine Beschädigung der elektronischen Schaltung verursachen.

Insbesondere wenn mehrere Bauelemente in einer Chipkarte angeordnet sind, ist die Gefahr des Schaltungsausfalles infolge von Beschädigungen durch mechanische Belastung der Schaltung sehr groß.

Üblicherweise werden die Chips auf die flexible Leiterkarte mittels Bondverfahren (DE-OS 32 35 650) oder mittels Direktkontaktierungsverfahren (DE-AS 29 20 12) montiert. Für Anwendungsfälle mit mehreren Chips herrscht das Bondverfahren vor. Sehr wichtig ist der anschließende mechanische Schutz und der Schutz vor Feuchte des Chips und der Kontaktleitungen zwischen Chip und Leiterkarte, der allgemein mit einer härtbaren Gieß- bzw. Abdeckmasse vorgenommen wird. Das Verlaufen der flüssigen Masse auf der Leiterfolie wird vor dem Aushärten meistens durch einen um das Chip und seine Kontaktierungsleitungen gelegten und mit der flexiblen Leiterkarte verklebten Ring verhindert. Eine derartige Anordnung ist in DE-OS 32 35 650 beschrieben. Nachteilig ist dabei, daß die Vergußmasse sich innerhalb des Ringes nicht völlig gleichmäßig verteilt, so daß sie nach dem Härten plangeschliffen werden muß.

Um dieses zumindest teilweise zu vermeiden, ist eine Verfahrensweise aus der Branche der Elektronikuhrenherstellung bekannt, bei der auf ein spezielles Glasfasergewebeplättchen einseitig flüssiges Epoxydharz aufgetragen wird und das Gewebe mit dem flüssigen Gießharz über das kontaktierte Chip und den Begrenzungsring gelegt und zumindest auf den Begrenzungsring gedrückt wird. Dadurch ergibt sich eine relativ ebene Versiegelungsfläche.

Nachteilig ist die Gefahr verbleibender Hohlräume im Montagebereich und die relativ hohe Verfahrensungenauigkeit.

Der Ring besteht meist aus PVC oder Glasepoxy, er kann aber auch gemäß DE 89 09 027.6 U1 aus biegesteifem Metall bestehen. Bei einer Verbiegung der Chipkarte folgt das Trägerelement der Biegung nicht oder nur teilweise und schützt so das Chip, eventuelle weitere elektronische Elemente und die Verbindungsdrähte. Auf dem gleichen Prinzip beruht die in DE-OS 34 20 051 dargelegte Lösung, wobei eine teilweise Auftrennung der Trägerelementverbindung zur Chipkarte bei starken Kartenverbiegungen erfolgt. Dadurch kann es aber unter extremen Belastungen zum Herausbrechen des Chips kommen. Um dieses zu vermeiden, wird, wie es nach EP 0 211 360 bekannt ist, zwischen Halbleiterchip und Kartenmaterial eine dünne, verstärkende Schicht, beispielsweise aus einem dünnen Netzgeflecht eingelegt. Gleichzeitig werden durch den sehr steifen Ring die hohen vertikalen Kräfte beim Laminieren der Chipkarten aufgenommen und im wesentlichen vom Chip oder den passiven Elementen ferngehalten. Eine ähnliche Funktion weist die in DE-OS 31 51 408 genannte Stütz schicht auf.

Durch das beim Laminieren von Plastikkarten auftretende plastische Fließen der Laminatfolien wirken jedoch Scherkräfte auf den Ring und die in seinem Inneren befindlichen Kontakte und Elemente. Eine Verschiebung des Ringes parallel zur Leiterfolie und Kontaktabrisse sind die Folge, wenn die geklebten Verbindungsstellen des Ringes zur Leiterfolie der Laminiertemperatur und den Scherkräften nicht standhalten.

Um diese genannten Probleme zu umgehen, werden deshalb zur Zeit vorwiegend Chips kleiner Kantenlänge (< 4 mm) in Chipkarten eingesetzt und zudem die Trägerelemente mit den Chips in Aussparungen der Plastikkarten eingesetzt bzw. eingepreßt. So können die einzelnen Trägerelemente außerhalb der Schaltung vorgeprüft werden. Die in eine Kartenseite eingesetzten Trägerelemente sind von der Karte zumindest bei starken Kartenverbiegungen aufgrund der schon beschriebenen biegefesten, geometrisch begrenzten Bauweise teilweise mechanisch entkoppelt. Mit dieser Lösung kann jedoch nur ein Chip pro Schaltung eingebracht werden. Sollen aber mehrere Chips und weitere Elemente in einer sehr flachen Schaltung, die außerdem noch starken Biegebelastungen unterworfen ist und eine über Teile der Karte reichende daten- und energieübertragende Antenne aufweist, montiert werden, sind die bisher genannten Lösungen nicht oder nur teilweise anwendbar.

In US-Patent 4.674.175 ist ein Gehäuse zum Einsatz in dünnen Plastikkarten angegeben. Nachteilig bei dieser Lösung ist, daß die Materialschichtungen des Gehäuses bezogen auf die Schichtmitte völlig unsymmetrisch sind und deshalb das Gehäuse bei Kartenverbiegungen zerstört werden kann. Auch ist ein schichtmittiges Einbetten des Gehäuses in kontaktlosen Chipkarten und ein gleichzeitiges schichtmittiges Anordnen der Antenne in der Plastikkarte nicht möglich. Damit besteht die Gefahr der Durchbiegung der Plastikkarten.

Nach EP 0 391 790 ist ein Gehäuse für elektronische Komponenten bekannt, bei dem die elektronischen Komponenten in einem mit Gießharz verfüllten Gehäuserahmen aus Kunststoff angeordnet sind und bei dem der Gehäuserahmen an seiner Unterseite mit einem metallischen Leiterrahmen verbunden ist.

Nachteilig ist hierbei, daß bei dieser Anordnung keine exakte Außengeometrie des Gehäuses erreicht werden kann, da die Vergußmasse innerhalb des Rahmens keinen ebenen Abschluß erzeugt. Ein ebener Abschluß wird nur durch ein nachträgliches, aufwendiges Planschleifen der Oberfläche oder durch das Anbringen eines Deckels erreicht.

Nach EP-A- 0036671 ist ein Gehaüse für elektronischen Bauelemente bekannt, das aus einem Schalenteil und einem Deckelteil besteht. Die Anschlußteile, die nach aussen führen, sind rechtwinklig abgebogen.

FR-A- 2 205 745 beschreibt ein zweiteiliges Gehäuse, wobei zwischen die zwei Teilen ein TAB-Filmträger angeordnet ist.

Aufgabe der vorliegenden Erfindung ist es, ein in dünne flexible Leiterkarten einsetzbares Miniaturgehäuse für Halbleiterbauelemente und/oder für passive elektronische Elemente anzugeben, wobei die elektronischen Elemente mittels Mikrodraht kontaktierbar und gegenüber den beim Plastikkartenlaminieren oder Plastikkartenspritzgießen auftretenden Drücken und Temperaturen beständig sind.

Die erfindungsgemäße Anordnung erhält man dadurch, daß zwei einteilige flächige Teile der Dicke vorzugsweise größer 200 µm, die einseitig in ihrem Zentrum eine vorzugsweis größer 80µm tiefe, flächige Kavität aufweisen, die größer der Fläche der elektronischen Komponenten ist und die aus vorzugsweise bis zu größer 200°C formstabilem biegesteifem, elektrisch isolierendem Material mit einer Zugfestigkeit von vorzugsweise größer 70 N/mm² und einer Reißdehnung von vorzugeweise größer 2 % bestehen, nach dem Befestigen der elektronischen Komponente in der Kavität des einen flächigen Teiles - der Basisschale - die Kavitäten mittels eines härtbaren, adhäsiven, elektrisch isolierenden Gießhares mit einer Reißdehnung vorzugsweise von >=1% und einer Härte von vorzugsweise >=70 Shore D und einer Temperaturbeständigkeit von vorzugsweise >= 150°C so ausgefüllt werden, daß nach dem Zusammenbringen der Basisschale und eines zweiten Teiles - der Deckschale - in deren Kavitäten sich die elektronischen Komponenten befinden, die Restkavitäten vollständig mit Gießharz gefüllt sind und die Ränder der Basis- und der Deckschale durch das gleiche Gießharz nach dem Härten des Gießharzes fest zusammengefügt sind.

Durch die genannte Anordnung und Verfahrensweise wird ein nahezu ideal schichtensymmetrisches, sehr flaches Gehäuse mit präziser Geometrie, hoher Biegesteifigkeit und begrenzter Elastizität und einer Beständigkeit gegenüber Drücken und Temperaturen erreicht, wie sie üblicherweise beim Laminieren von Plastikkarten auftreten. Die elektronischen Komponenten sind in der neutralen Biegelinie des Miniaturgehäuses angeordnet und durch das Klebe- und Gießharz und durch die Basis- und Deckschale vollständig gegen Feuchte und mechanische Einflüsse geschützt. Weist das Halbleiterchip selbst eine Antenne auf, kann der Energie- und Signalaustausch ungehindert die Schalenwand passieren. Vorteilhaft ist es, die Gehäuseschale mittels Spritzgießverfahren aus flüssig-kristallinen Kunststoffen herzustellen. Mittels Spitzgießen sind kostengünstig präzise Teile herstellbar, und mit flüssig-kristallinen Werkstoffen lassen sich speziell dünnwandige, flächige Teile hoher thermischer und mechanischer Beständigkeit verzugsfrei herstellen.

Weiterhin ist es vorteilhaft, die Unterseite einer mit metallischen Leiterzügen und mit einem Durchbruch in der Größe der flächenhaften Ausdehnung der Kavität der Basisschale versehene Leiterplatte so auf der Oberfläche des Schalenrandes der Basisschale mittels Klebeharz zu befestigen, daß der Durchbruch der Leiterkarte und die Kavität der Basisschale nahezu deckungsgleich übereinander liegen. Die Kontaktierungsstellen der elektronischen Komponenten und die Kontaktierungsstellen der Leiterkarte werden über Mikrodrähte, vorzugsweise mittels Ultraschallbondverfahren, verbunden.

Ferner ist es zweckmäßig, die Flächenausdehnung der Kavität der Deckschale gegenüber der der Basisschale zu vergrößern, um nicht durch die Oberfläche der Ränder der Deckschale die Mikrodrähte zu beschädigen. Mittels der zwischen Basis- und Deckschale geklebten, strukturierten Leiterkarte und der Mikrodrahtkontaktierung zwischen elektronischen Komponenten und Leiterkarte ist es möglich, den Daten- und Energiefluß leistungsgebunden über die Leiterkarte zu führen und z.B. mehrere Gehäuse bzw. Chips miteinander zu verbinden. Die elektronischen Komponenten verbleiben weiterhin in der neutralen Biegelinie der Leiterkarte, das Miniaturgehäuse bleibt nahezu ideal symmetrisch. Die Mikrodrahtbrücken verlaufen in einem geringen Bogen nahezu waagerecht von den elektrischen Komponenten zur Leiterkarte. Die Leiterkarte selbst bleibt in schichtensymmetrischer Lage und bietet sehr günstige Voraussetzungen für das Einlaminieren in Plastikkarten.

Auch ist es zweckmäßig, auf die Oberfläche des Schalenrandes der Basisschale eine strukturierte, mikrodrahtkontaktierfähige Metallschicht auf zubringen und das Chip und eventuell pasive elektronische Bauelemente mit dieser Metallschicht über Mikrodrähte zu kontaktieren. Damit wird der Schalenrand als Träger einer Antenne für den Daten- und Energiefluß nutzbar.

Ferner ist es vorteilhaft, die Ränder der Schalen so zu gestalten, daß sie wechselseitig sacklochartige Vertiefungen und stiftförmige Erhöhungen tragen, die so gestaltet sind, daß beim Zusammenlegen der Basisschale mit der Deckschale mit oder ohne zwischenliegender Leiterkarte, wobei die Leiterkarte Durchbrüche aufweisen muß, die Stifte der einen Schale in die beiden Schalen und die Leiterkarte zueinander justieren und arretieren.

Ferner ist es möglich, die Ecken der Gehäuseschalen abzurunden bzw. die Gehäuseschalen insgesamt rund zu gestalten, um mechanische Spannungspitzen beim Laminieren zu reduzieren. Dadurch werden bei Biegeund Torsionsbeanspruchungen die mechanischen Belastungen des Gehäuses und des Laminates verringert.

Die Erfindung wird im folgenden anhand von einem Ausführungsbeispiel näher erläutert. In den zugehörigen Zeichnungen erläutern die Figuren 1 bis 3 die erfindungsgemäße Anordnung. Im einzelnen zeigen:
Figur 1 eine Schnittdarstellung eines Miniaturgehäuses mit eingeklebtem Chip mit dem bei der Erfindung bevorzugten System für des Zusammenfügen der Gehäuseschalen,
Figur 2 eine erfindungsgemäße Leiterkarte mit Gehäuse und mit kontaktiertem Halbleiterchip und
Figur 3 die Basisschale mit aufgeklebter Leiterkarte und kontaktiertem Halbleiterchip in Draufsicht.

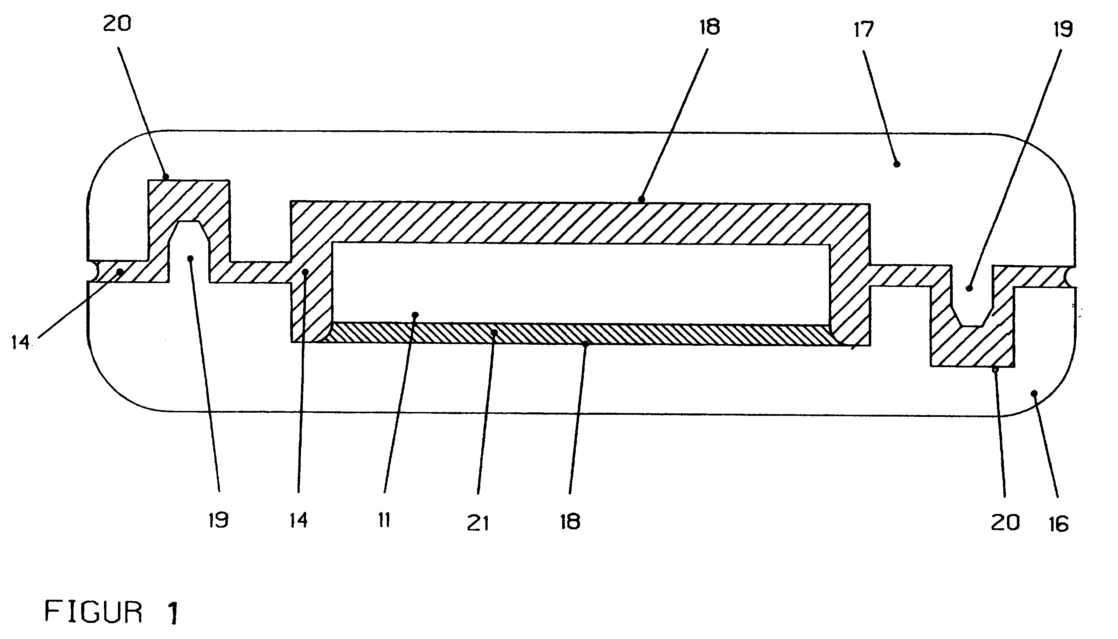

In Figur 1 ist in Seitenansicht die Schnittdarstellung eines Miniaturgehäuses entlang der Gehäusediagonale mit eingeklebtem Chip 11 gezeigt. Die Gesamtdicke der Basisschale 16 und er Deckschale 17 beträgt jeweils 250µm. Die Kavität 18 der Schalen 16 und 17 ist jeweils 5,0 x 5,0 mm2 groß und besitz eine Schalendicke von 100µm.
Im Schalenrand befinden sich ausgehend von der Oberfläche des Schalenrandes Justierlöcher 20 mit einer Tiefe von 200µm und einem Durchmesser von 450µm. Deckungsgleich zum Mittelpunkt dieser justierlöcher 20 befinden sich auf dem Schalenrand der Gegenschale Justierzapfen 19 mit einem Durchmesser von 300µm und einer Länge von 200µm. Die Justierzapfen 19 weisen eine konische Spitze auf. Auf dem Boden der Kavität 18 der Basisschale 16 ist mittels Chipkleber 21 ein 4,0 x 4,0 mm2 großes und 250µm dickes Halbleiterchip 11 mit integrierter Daten- und Energieantenne befestigt. Mittels Gießharz 14 wurde das Chip 11, die Kavität 18 der Basisschale 16 so beschichtet, daß nach dem Aufstecken und Andrücken der Deckschale 17 die Kavitäten 18 bzw. Hohlräume der Schalen 16 und 17 augefüllt sind und die Oberflächen der Schalenränder vollständig und dicht miteinander verklebt sind. Die Kanten der Schalen 16 und 17 sind mit einem Radius R = 100 µm verrundet.

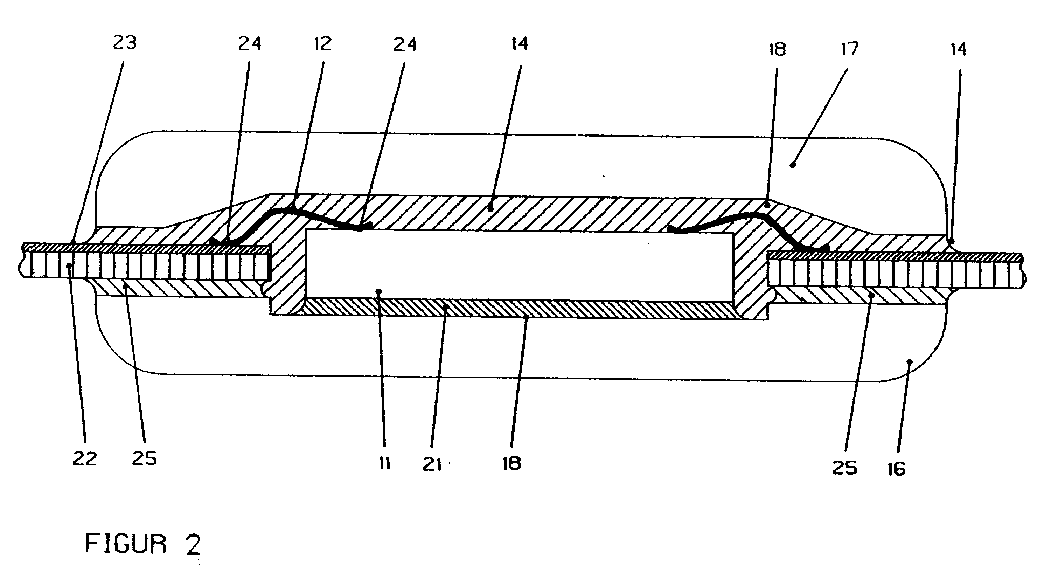

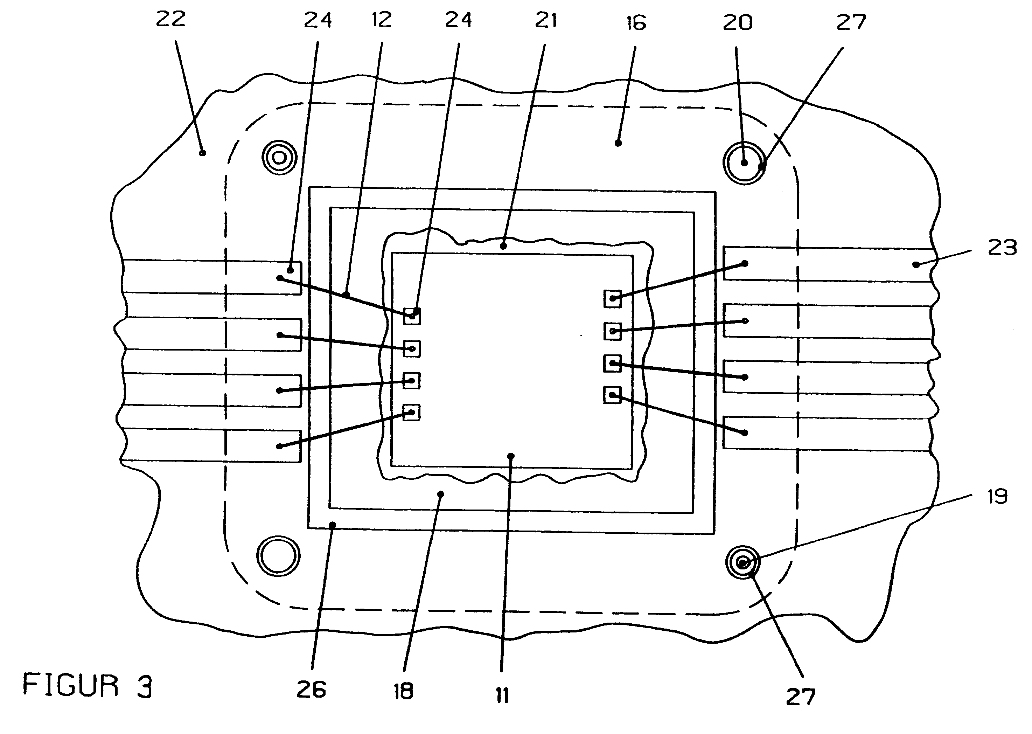

Die Figuren 2 und 3 erläutern eine Ausführungsform der erfindungsgemäßen Anordnung mit Gehäuseschalen.

In Figur 2 ist das Gehäuse mit eingeklebtem und kontaktiertem Halbleiterchip 11 und zwischengeklebter, strukturierter Leiterkarte 22 in seitlicher Schnittdarstellung dargestellt.
Auf die Oberfläche des Randes der Basisschale 16 wurde mittels temperaturbeständigem Leiterkartenkleber 25 eine 100µm dicke Leiterkarte 22 geklebt, die auf ihrer Oberseite eine metallische Struktur 23 trägt. Die Leiterkarte 22 weist einen Durchbruch 26 auf, der in seiner Größe und Lage der Kavität 18 der Basisschale 16 entspricht. Ausgehend von den Kontaktierungsstellen 24 des auf den Boden der kavität 18 der Basisschale 16 mittels Chipkleber 21 befestigten Halbleiterchip 11 sind Mikrodrähte 12 zu den Kontakierungsstellen 24 auf der Leiterkarte 22 gezogen. Die Kavität 18 der Deckschale 17 weist gegenüber der Kavität der Basisschale 16 eine Vergrößerung um die Länge der Kontakierungsstellen 24 auf der Leiterkarte 22 auf. Die Deckschale 17 wurde mittels Gießharz 14 vollständig und blasenfrei auf der Basisschale 16 bzw. auf der Leiterkarte 22 befestigt.

In Figur 3 wird die Basisschale 16 mit aufgeklebter Leiterkarte 22 und kontaktiertem Chip 11 in Draufsicht gezeigt. In der Nähe der Ecken der Basisschale 16 sind Justierlöcher 20 und Justierzapfen 19 angeordnet. Die Leiterplatte 22 weist dementsprechende Justierlöcher 27 auf. Die Ecken der Basisschale 16 sind mit einem Radius R = 300 µm verrundet.

### Auflistung der verwendeten Bezugszeichen

- 11: Chip
- 12: Mikrodraht
- 14: Gießharz
- 16: Basisschale
- 17: Deckschale
- 18: Kavität
- 19: Justierzapfen
- 20: Justierloch
- 22: Leiterkarte
- 23: metallische Struktur
- 24: Kontaktierungsstelle
- 26: Leiterplattendurchbruch
- 27: Leiterkartenjustierloch

## Patentansprüche

1. Leiterkarte mit Miniaturgehäuse für elektronische Komponenten, wobei zwei Gehäuseschalen als Basisschale (16) und Deckschale (17) ausgebildet sind und in ihrem Zentrum eine Kavität (18) aufweisen, die größer der Fläche der aufzunehmenden elektronischen Komponenten ist, wobei
- die Gehäuseschalen (16;17) aus bis zu 200°C formstabilem, biegesteifem, elektrisch isolierendem Material bestehen,
- auf der Oberfläche des Randes der Basisschale (16) die Unterseite einer Leiterkarte (22) mittels Leiterplattenklebers (25) befestigt ist ,
- die Leiterkarte (22) an der Oberseite mit metallischen Leiterzügen (23) und Kontaktierungsstellen (24) strukturiert ist und mit einem Durchbruch (26) in der Größe der Kavität der Basisschale (16) versehen ist,
- die elektronischen Komponenten auf dem Boden in der Kavität (18) der Basisschale (16) angeordnet sind,
- die Kavitäten (18) mit Gießharz (14) ausgefüllt sind, und
- die Ränder der Gehäuseschalen (16;17) mit Hilfe des Gießharzes (14) miteinander verklebt sind.

2. Miniaturgehäuse nach Anspruch 1, **dadurch gekennzeichnet**, daß die Kontaktrierungsstellen (24) der elektronischen Komponenten (11) und die Kontaktierungsstellen (24) der Leiterkarte (22) über Mikrodrähte (12) verbunden sind.

3. Miniaturgehäuse nach Anspruch 1 oder 2, **dadurch gekennzeichnet**, daß die Schalenräder der Basisschale (16) und der Deckschale (17) Justierlöcher (20) und Justierzapfen (19) aufweisen, die nach dem Zusammenfügen der Gehäuseschalen (16;17) ineinandergreifen.

## Claims

1. Circuit board with a miniature casing for electronic components with two casing shells being designed as base shell (16) and cover shell (17) and present a cavity (18) in their centre which cavity is greater than the surface of the electronic components to be held, wherein
- the casing shells (16;17) consist of a material which is dimensionally stable at a temperature of up to 200°C, resistant to bending, and electrically insulating,
- the lower side of the circuit board (22) is fixed by means of circuit-board glue (25) to the surface of the edge of the base shell (16),
- the circuit board (22) has a structure made of metallic conductor runs (23) and connection pads (24) on the upper side, and it is provided with an opening (26) which is of the same size as the cavity in the base shell (16),
- electronic components are arranged on the bottom of the cavity (18) of the base shell (16),
- cavities (18) are filled out with casting resin (14), and
- the edges of the casing shells (16;17) are glued together by means of the casting resin (14).

2. Miniature casing as claimed in claim 1, **characterized in that** the connection pads (24) of the electronic components (11) and the connection pads (24) of the circuit board (22) are connected via microwires (12).

3. Miniature casing as claimed in claim 1 or 2, **characterized in that** the shell edges of the base shell (16) and of the cover shell (17) present adjusting holes (20) and adjusting pins (19) which engage into one another when the casing shells (16;17) have been assembled.

## Revendications

1. Carte imprimée à boîtier miniaturisé pour composants électroniques, deux coques de boîtier étant formées comme coque de base (16) et coque de couverture (17) et présentant en leur centre une cavité (18) de surface supérieure à celle des composants électroniques devant être logés,
- les coques de boîtier (16;17) étant réalisées en matériau isolant électrique résistant à la flexion et indéformable jusqu'à 200°C,
- la face inférieure d'une carte imprimée (22) étant fixée par de la colle pour cartes imprimées (25) à la surface du bord de la coque de base (16),
- la face supérieure de la carte imprimée (22) présentant une structure à lignes conductrices (23) et points de contact (24) et étant pourvue d'une ouverture (26) de la taille de la cavité de la coque de base (16),
- les composants électroniques étant disposés sur le fond de la cavité (18) de la coque de base (16),
- les cavités (18) étant remplies de résine moulée (14) et
- les bords des coques de boîtier (16;17) étant collés l'un sur l'autre au moyen de la résine moulée (14).

2. Boîtier miniaturisé selon revendication 1, **caractérisé en ce que** les points de contact (24) des composants électroniques (11) et les points de contact (24) de la carte imprimée (22) sont reliés par des fils minces (12).

3. Boîtier miniaturisé selon revendication 1 ou 2, **caractérisé en ce que** les bords de la coque de base (16) et de la coque de couverture (17) présentent des orifices d'ajustage (20) et des tenons d'ajustage (19) s'adaptant après assemblage des coques de boîtier (16;17).
